# EUROPEAN PATENT APPLICATION

(11) **EP 2 270 885 A2**
(43) Date of publication of application: **05.01.2011**
(21) Application number: 10011258.0
(22) Date of filing: 07.07.1998
(51) Int. Cl.: H01L 33/50

(54) **Transparent coating member for light-emitting diodes and fluorescent color light source**

(30) Priority: 07.07.1997 JP 18103597
(62) Divisional of application: 06021272.7
(71) Applicant: Asahi Rubber Inc., Kawaguchi-shi, Saitama-ken (JP); SANKEN ELECTRIC CO., LTD., Niiza-shi Saitama (JP)
(72) Inventor: Tasaki, Masutsugu, Nishishirakawa-gun Fukushima-ken (JP); Ichikawa, Akira, Nishishirakawa-gun Fukushima-ken (JP); Odaki, Tsutomu, Nishishirakawa-gun Fukushima-ken (JP); Takagi, Kazuhisa, Nishishirakawa-gun Fukushima-ken (JP)
(74) Representative: Müller-Boré & Partner Patentanwälte

(57) **Abstract**

The present invention relates to a method of producing a fluorescent color light source, comprising a step of dispersing a fluorescent substance in a resin to obtain a fluorescent-substance-containing resin; a step of molding the fluorescent-substance-containing resin to obtain a transparent coating member; and a step of mounting the transparent coating member on a light emitting diode, a transparent coating member mountable on a light-emitting diode, comprising a fluorescent substance, and a fluorescent color light source.

## Description

### BACKGROUND OF THE INVENTION

This invention relates to a transparent coating member to be mounted on a light-emitting diode (hereinafter, "LED") and a light source for changing the color of a light emitted from an LED by mounting the coating member on the LED or forming a coating layer containing a fluorescent substance on the surface of the LED.

As well-known, the LED is a crystal body having a p-n junction. Upon the application of a forward voltage, electrons are injected from the n region to the p-n junction and holes are injected from p region to the p-n junction. A light is emitted when the electrons and holes are recombined. Accordingly, free electrons are combined and energy released during this recombination is radiated as a light. Thus, there exist LEDs of limited colors. In other words, LEDs having a red LED chip emit only a red light; LEDs having a green LED chip emit only a green light; and LEDs having a blue LED chip emit only a blue light.

However, there has recently been a large demand for LEDs capable of changing a light emitted therefrom in order to meet multi-purpose applications. A color changing method for meeting such a demand is, for example, such that a suitable combination of red, green and blue LED chips are set in the LED and the color of the light emitted from the LED is changed by causing a different combination of chips to emit light.

Such an LED results in a complicated constructional design since four terminals: three different anode terminals of the red, green and blue LED chips and a cathode terminal, are necessary. The most fatal problem is that, since three different chips are set in the LED, a color balance is lost if any one of the chips is broken, with the result that a desired color cannot be obtained.

Further, in recent years, a white LED lamp has been proposed in which a layer of YAG (yttrium aluminate) fluophor is provided on a blue LED chip (Nikkei Sangyo Shinbun, Sept. 13, 1991 issue). This white LED lamp is designed to generate a white light by a light excited by the layer of fluophor and the afterglow of the blue LED chip. If a cap or a sheet containing a coloring agent is mounted on such a white LED lamp, a light of a desired color can be obtained.

However, the above white LED lamp has various problems that a high degree of application technique is required due to only a very small amount of fluorescent substance on the blue LED chip, a large variation of the color caused by a slight error and the application of a fine amount, and a price per lamp is very expensive.

On the other hand, it is in reality very difficult to produce LEDs of uniform quality, and the color and luminance of the produced LEDs unavoidably vary. It is a very important problem how such variations can be suppressed without increasing production costs. Up to now, the variations have not yet sufficiently been suppressed.

### SUMMARY OF THE INVENTION

The present invention has been developed as a result of studies to solve the above-mentioned various problems and an object thereof is to provide a transparent coating member for a LED which can easily change the color of a light emitted therefrom to a desired color.

It is another object of the present invention to provide a fluorescent color light source which can easily change the color of a light irradiated therefrom and diffuse the light of a stable color at a high luminance and is easy to maintain and inexpensive.

The invention is directed to a transparent coating member mountable on a light-emitting diode, comprising a fluorescent substance.

The invention is also directed to a fluorescent color light source comprising a light-emitting diode, and a transparent coating portion on the light-emitting diode, the transparent coating portion including a fluorescent substance.

The wavelength of emitted light peculiar to the light-emitting diode is changed by the fluorescent substance contained in the coating portion to change the luminescent color.

These and other objects, features and advantages of the present invention will become more apparent upon a reading of the following detailed description and accompanying drawings.

### BRIEF DESCRIPTION OF THE DRAWINGS

FIG. 1 is a schematic section of a fluorescent color light source in which a fluorescent color cap as a coating member (cap-shaped) of the invention is mounted on a lamp-type LED;
FIG. 2 is a schematic section of a fluorescent color light source in which a fluorescent color cap as another coating member (cap-shaped) of the invention is mounted on the lamp-type LED;
FIGS. 3A and 3B are schematic sections of fluorescent color light sources in which a coating member (sheet-shaped) as still another embodiment of the invention is mounted on a chip-type LED and a segment-type LED, respectively;

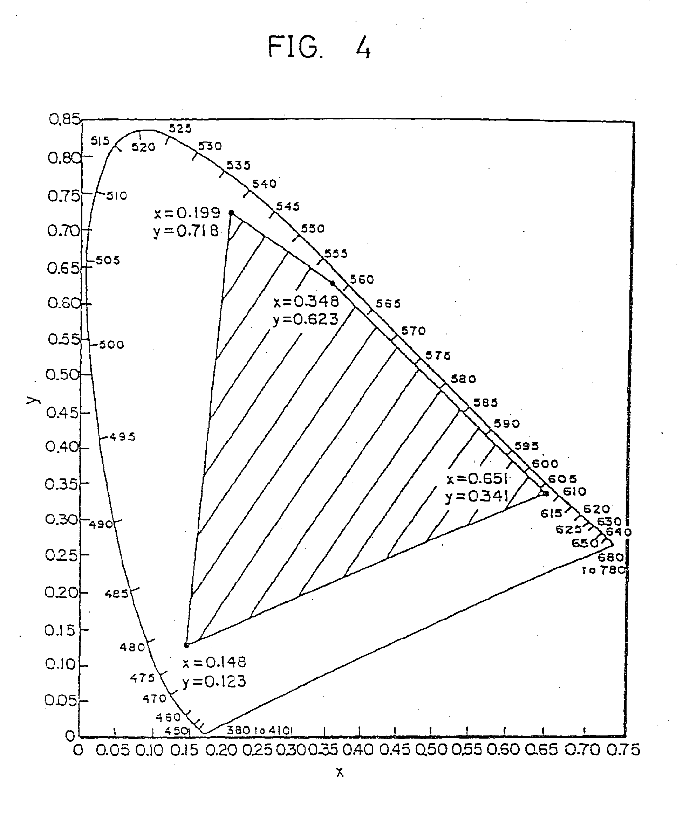

FIG. 4 is a chart showing a variable range of a light diffusely emitted from the fluorescent color source of the invention by CIE (International Committee on Illumination) standard chromaticity diagram;
FIG. 5 is a section of a fluorescent color cap according to the invention in which a light gathering mechanism is provided at its leading end portion;
FIG. 6 is a graph showing a spectral wavelength of a blue LED used in a production example 23;
FIG. 7 is a graph showing a spectral wavelength when the fluorescent color cap is mounted on the blue LED in the production example 23;
FIG. 8 is a graph showing a spectral wavelength when an elastic sheet containing a fluorescent substance is mounted on a blue LED in a production example 24;
FIG. 9 is a graph showing a spectral wavelength when a colored cap is mounted in a production example 28;
FIG. 10 is a graph showing a spectral wavelength when a colored cap is mounted in a production example 29; and
FIG. 11 is a graph showing a spectral wavelength when a fluorescent color cap is mounted in a production example 32.

### DETAILED DESCRIPTION OF THE PREFERRED EMBODIMENTS OF THE INVENTION

The significant feature of the transparent coating member for an LED according to the invention lies in the fluorescent substance contained therein. As opposed to the prior art method for generating a light of a desired color by applying a fine amount of fluorescent substance to the LED chip, light of a desired color can be generated by mounting the inventive transparent coating member on an LED without necessitating a high level of technique.

The fluorescent substance may be preferably an yttrium aluminate fluophor or perylene fluophor. Further, the coating member may be preferably cap-shaped or sheet-shaped. In the case of the cap-shaped coating member, a light gathering mechanism may be provided at a leading end portion thereof.

Also, a fluorescent color light source is produced by mounting a transparent coating member on a light-emitting diode or forming a coating layer containing a fluorescent substance on the surface of the light-emitting diode to thereby change the wavelength of an emitted light peculiar to the light-emitting diode by the fluorescent substance contained in the coating member or coating layer, and thereby change the luminescent color.

The fluorescent color light source is such that the light diffusely emitted through the coating member or coating layer has a luminescent color within a range defined by (x, y) = (0.148, 0.123), (0.199, 0.718), (0.651, 0.341) and (0.343, 0.623) in chromaticity coordinate systems, and more preferably in a range defined by (x, y) = (0.27, 0.19), (0.19, 0.24), (0.35, 0.48) and (0.48, 0.37) in chromaticity coordinate systems. The fluorescent color light source may be such that a coating member or coating layer containing a coloring agent is further mounted or formed on the coating member or coating layer. Preferably, a holder mechanism may be provided in a desired position of contact surface of the light-emitting diode and the coating member. The light-emitting diode on which the coating member or coating layer may be preferably mounted or formed is a blue light-emitting diode or green light-emitting diode having a high energy.

The color of emitted light to be diffused while passing through the coating member can be adjusted by partially changing the concentration of the fluorescent substance in the coating member. For example, with reference to a production example 33 to be described later, if the fluorescent substance is uniformly and dispersely mixed in a fluorescent color cap, a light emitted through a leading end portion of the cap is: x = 0.2346, y = 0.2365 and a light emitted through a side surface portion of the cap is: x = 0.3095, y = 0.3389. In other words, the color of the emitted light differs depending on whether the light passes through the leading end portion of the cap or the side surface portion thereof. If another cap containing a specified amount of fluorescent substance is further mounted on the leading end portion of the cap, i.e. the concentration of the fluorescent substance is changed at the leading end portion and the side surface portion, the light emitted through the leading end portion is: x = 0.3060, y = 0.3355 and is the same color as the color of the light emitted through the side surface portion.

Fluorescent substances usable for the inventive transparent coating member for an LED are known fluorescent substances such as fluophors, fluorescent pigments and fluorescent dyes. Organic fluophors include allylsulfoamide-melamine-formaldehyde condensation dyes and perylene fluophors, whereas inorganic fluophors include aluminates, phosphates, silicates. Among these substances, perylene fluophors and yttrium aluminate are particularly preferable since they are usable over a long term.

Additives to be added to the fluophors include, for example, cerium, europium, manganese, gadolinium, samarium, terbium, tin, chromium, etc. Cerium is most preferable among these. An amount of additive is preferably in a range of 0.1 to 10 mol% to the fluophor.

A preferable combination of the fluophor and additive are yttrium aluminate and cerium.

The mode of the inventive transparent coating member for an LED is not particularly limited and come, for example, in a caplike shape and a sheetlike shape in conformity with the shape of the LED. In order to make the coating member into a caplike shape, for example, the fluorescent substance and a bonding resin may be mixed and the resulting mixture may be molded using a mold and a heat press. In order to make the coating member into a sheetlike shape, the fluorescent substance and a bonding resin may be melted and kneaded and may be molded according to an inflation method, T-die extrusion, solvent casting, calendering. Further, a sheetlike shape may be realized by coating the fluorescent substance on a base sheet made of a plastic film. As such a coating method may be adopted a method for applying a fluorescent substance dissolved in an organic solvent to the base sheet and drying it by hot air or a method for applying a synthetic resin emulsion to the base sheet and drying it to form a polymer film thereon.

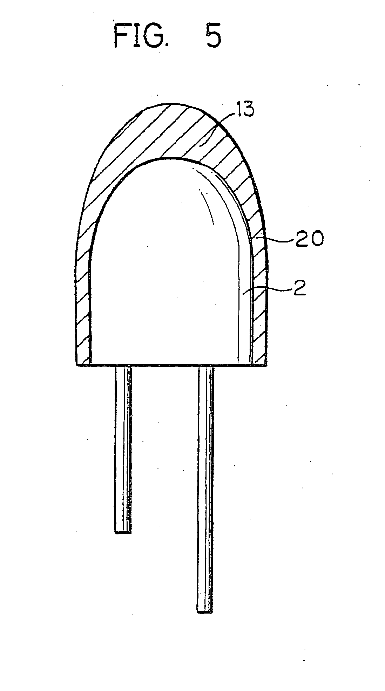

In the case that the transparent coating member for an LED is cap-shaped, a light gathering mechanism may be provided at its leading end portion. Luminance can be increased by such a mechanism, thereby achieving an efficient illumination with a little energy. The light gathering mechanism may be constructed, for example, by a lens construction. A specific example of construction is shown in FIG. 5. A light gathering portion may be provided at the leading end portion of the cap by being integrally molded with other parts using a mold in which the leading end portion is thicker than the other parts or by adhering or mounting a separately manufactured light gathering portion on the leading end portion of the cap.

An amount of the fluorescent substance used in the coating member is preferably in a range of 0.0001 to 10 weight parts in the case of organic fluophor and in a range of 0.5 to 70 weight parts in the case of inorganic fluophor per 100 weight parts of bonding resin.

Resins usable for the coating member according to the invention include, for example, acrylic resin, polycarbonate resin, polystyrene resin, polyester resin, epoxy resin, polypropylene resin, polyethylene resin, silicone elastomer, polystyrene thermoplastic elastomer, polyolefin thermoplastic elastomer, polyurethane thermoplastic elastomer. Among these, silicone elastomer and the like are preferably usable.

Any known LED can be used as an LED used in the present invention. For example, Ga:ZnO red LED, GaP:N green LED, GaAsP red LED, GaAsP orange/yellow LED, GaAlAs LED, In GaAlP orange/yellow LED, GaN blue LED, SiC blue LED, II-VI blue LED may be used.

Further, the LED comes in any mode. For example, a LED lamp, a chip type LED or a segment type LED, etc. may preferably be used.

The wavelength of the light emitted from the LED can be changed to a desired one by mounting the above coating member on the LED or forming a coating layer containing a fluorescent substance on the surface of the LED.

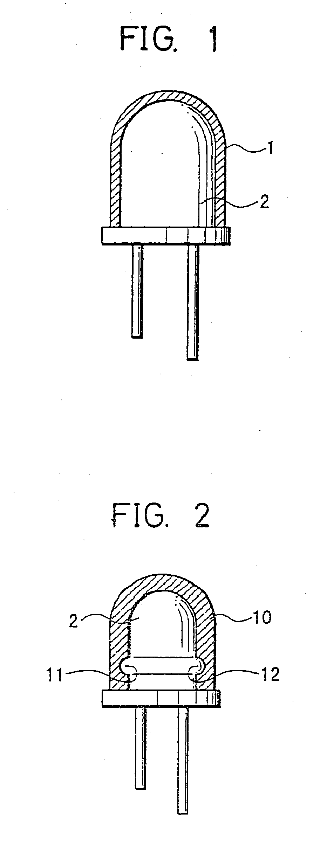

In order to mount the coating member on the LED, it may be engaged with the LED in the case of a cap-shaped coating member. In order to more securely mount the coating member, a holder mechanism may be provided at a peripheral portion of the coating member. With reference to FIG. 1, an inventive coating member (cap) 1 containing a fluorescent substance is directly detachably mounted on an LED 2. Since a cap 10 shown in FIG. 2 is relatively hard, a recess 11 is formed in the cap 10 and a projection 12 is formed on the LED 2 in order to prevent a relative displacement and a disengagement when the cap 10 is mounted on the LED 2. The cap 10 and the LED 2 are disengageably engaged with each other by one operation. The recess 11 and the projection 12 may have an annular configuration along the circumference of the cap or may be formed in a plurality of positions along a circumferential direction at specified intervals. Further, the recess 11 and the projection 12 may be formed on the LED 2 and the cap 10, respectively, converse to the former construction.

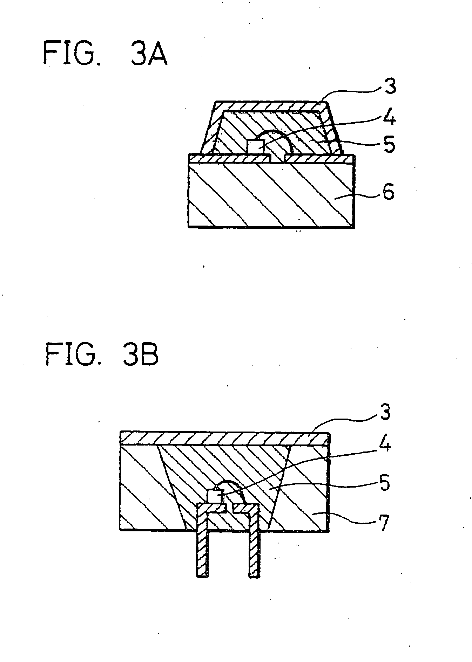

In the case of the sheet-shaped coating member, it may be placed on the surface of the LED. At this time, it is preferable to adhere the sheet-shaped coating member to the LED. A known method such as a thermal adhesion, ultrasonic sealing, high-frequency bonding or a gluing using an adhesive or the like may be used as a method for adhering the sheet-shaped coating member to the LED. Here, in order to improve adhesiveness, the surface of the sheet-shaped coating member may be oxidized by chemicals or by being subjected to gas flames or by means of corona discharge by being brought into contact with a surface electrode. For example, FIGS. 3A and 3B are side views in section of fluorescent color light sources in which sheet-shaped coating members are mounted on LEDs. A sheet-shaped coating member 3 is mounted on a chip type LED in FIG. 3A, while being mounted on a segment type LED in FIG. 3B.

In order to form a coating layer containing the fluorescent substance on the surface of the LED, a known method such as a resin coating or a printing method may be adopted. For example, a bonding resin may be dissolved in a solvent and coated on the surface of the LED after the fluorescent substance is added thereto.

The color of the light diffusely emitted from the LED having the coating member mounted thereon or having the coating layer formed thereon is preferably in a range defined by (x, y) = (0.148, 0.123), (0.199, 0.718), (0.651, 0.341), (0.343, 0.623) in the chromaticity coordinate systems. If the emission would fall within such a range, a variety of illuminations could be realized and a color reproduction as a video image is thought to be sufficient. Further, if the color of the emitted light is in a range defined by (x, y) = (0.27, 0.19), (0.19, 0.24), (0.35, 0.48), (0.48, 0.37) in the chromaticity coordinate systems, i.e. it is close to white, the color of the emitted light can easily be adjusted to a desired color.

In other words, if the color of the light emitted from the LED is adjusted to white by mounting or forming the coating member or coating layer, the emitted light can be adjusted to have a desired color by using a coloring agent. In such a case, the coloring agent may be contained in the coating member or coating layer together with the fluorescent substance or a separate coating member or coating layer containing the coloring agent may further be mounted or formed thereon.

The following can be used as a coloring agent. For example, yellow led, yellow zinc, cadmium yellow, yellow iron oxide, mineral fast yellow, nickel titanium yellow, naphthol yellow S, Hansa yellow G, Hansa yellow 10G, benzine yellow G, benzine yellow GR, guinoline yellow lake, permanent yellow NCG, tartrazine lake can be used as a yellow pigment. Chrome orange, molybdenum orange, permanent orange GTR, pyrazolone orange, vulcan orange, benzine orange G can be used as an orange pigment. Condensation azo dye, red iron oxide, cadmium red, red lead, cadmium mercuric sulfide, permanent red 4R, lithol red, pyrazolone red, watching red calcium salt, lake red D, brilliant-carmine 6B, eosine lake, rhodamine lake B, alizarin lake, brilliant-carmine 3B can be used as a red pigment. Manganese violet, fast violet B, methyl violet lake can be used as a violet pigment. Iron blue, cobalt blue, alkali blue lake, Victoria blue lake, phthalocyanine blue, metal-free phthalocyanine blue, phthalocyanine blue partial chloride, fast sky blue can be used as a blue pigment. Chrome green, chromium oxide, pigment green B, malachite green lake can be used as a green pigment. Hydrozincite, titanium oxide, antiony white, zinc sulfide, barite powder, barium carbonate, clay, silica, white carbon, talc, alumina white can be used as a white pigment. It is appropriate to use the above coloring agents in a range of 0.001 to 0.1 weight part, particularly 0.01 to 0.05 weight parts per 100 weight parts of bonding resin.

The LED on which the above coating member or coating layer are mounted or formed is preferably a blue LED having a high energy. However, it may be a green LED or other LED.

By using the coating member according to the invention, the luminescent color can finely be adjusted. For example, this coating member makes LEDs having an emitted light beyond a permissible range due to a variation during the manufacturing into a one having an emitted light within this permissible range. With reference to a production example 34, a desired luminescent color within a range of x = 0.2886 to 0.3046, y = 0.3102 to 0.3165 can be obtained by mounting a fluorescent color cap containing 10.0 parts of YAG fluophors, 10.5 parts thereof, 11.0 parts thereof, and 11.5 parts thereof on the LED when, for example, a current flowing into a blue LED is 5mA, 10mA, 20mA and 30mA, respectively. It should be noted that the observation or measurement was carried out by means of a spectrophotometer "PR-704" through an integrating sphere or not through an integrating sphere.

### [Examples]

### Production Example 1

1.5 parts of NKP-8306 (fluophor produced by Nippon Keiko Kagakusha) were dispersed as fluorescent substance in silicone rubber, and a fluorescent color cap having a thickness of 0.5 mm was molded using a mold and a heat press. Further, a blue LED which emits a light defined by x = 0.1490, y = 0.1203 in accordance with the CIE (Committee on International Illumination) standard calorimetric system (hereinafter, "chromaticity coordinate systems") was used. When this blue LED was caused to emit a light with the fluorescent color cap mounted thereon, a diffused white light having a yellow tint which is defined by x = 0.3912, y = 0.4322 in the chromaticity coordinate systems was observed. In this example, the measurement was carried out through the integrating sphere.

In the above case, the luminance of the blue LED itself was 32 cd/m². However, by mounting the fluorescent color cap according to the invention to change the color, the luminance is increased to 66 cd/m². Directivity peculiar to the LED is reduced and the luminescent color was diffused by the entire surface of the fluorescent color cap.

### Production Example 2

An amount of NKP-8306 (fluophor produced by Nippon Keiko Kagakusha) added was changed from 1.25 parts to 1.07 parts to 0.94 parts to 0.83 parts, and to 0.75 parts. These various amounts of NKP-8306 were dispersed as fluorescent substance in silicone rubber, and fluorescent color caps having a thickness of 0.5 mm were molded using the same mold and heat press as the example 1. Further, these fluorescent color caps were mounted on blue LEDs which emit a light defined by x = 0.1490, y = 0.1203 in accordance with the chromaticity coordinate systems, and the blue LEDs were caused to emit a light. TABLE-1 below shows the resulting colors of the diffused emitted lights. In this example, the measurement was carried out through the integrating sphere.

**TABLE-1**

| Fluorescent Substance | Chromaticity Coordinates | Luminescent Color |
|---|---|---|
| 1.25 Parts | X = 0.3752 | White |
| Dispersed | Y = 0.4153 | |
| 1.07 Parts | X = 0.3460 | White |
| Dispersed | Y = 0.3901 | |
| 0.94 Parts | X = 0.3319 | White |
| Dispersed | Y = 0.3780 | |
| 0.83 Parts | X = 0.3094 | White having |
| Dispersed | Y = 0.3536 | a blue tint |
| 0.75 Parts | X = 0.2916 | White having |
| Dispersed | Y = 0.3368 | a blue tint |

As is clear from the results of TABLE-1, it was confirmed that the amount of fluorescent substance added could control the luminescent color. Particularly in the above case, it was observed that luminance of the emitted light was highest at 70 cd/m² when 1.25 parts of fluorescent substance was dispersed. The thickness of the fluorescent color cap according to the invention may be uniform or may partially be varied to diffuse the light or change the color thereof. Fluorescent color cap can be designed according to the purpose.

### Production Example 3

NKP-8306 (fluophor produced by Nippon Keiko Kagakusha) and gadolinium oxide as an additive were mixed at a ratio of 10:2. This mixture was dispersed in 0.75 parts of silicone rubber and a fluorescent color cap having a thickness of 0.5 mm was molded using a mold and a heat press. When this color cap was mounted on a blue LED which emits a light defined by x = 0.1490, y = 0.1203 in the chromaticity coordinate systems, a diffused white light having a blue tint which is defined by x = 0.2971, y = 0.3485 in the chromaticity coordinate systems was observed. In this example, the measurement was carried out through the integrating sphere.

### Production Example 4

NKP-8306 (fluophor produced by Nippon Keiko Kagakusha) and gadolinium oxide as an additive were mixed at a ratio of 10:4. This mixture was dispersed in 0.75 parts of silicone rubber and a fluorescent color cap having a thickness of 0.5 mm was molded using a mold and a heat press. When this color cap was mounted on a blue LED which emits a light defined by x = 0.1490, y = 0.1203 in the chromaticity coordinate systems, a diffused white light having a blue tint which is defined by x = 0.2985, y = 0.3529 in the chromaticity coordinate systems was observed. In this example, the measurement was carried out through the integrating sphere.

### Production Example 5

NKP-8306 (fluophor produced by Nippon Keiko Kagakusha) and gadolinium oxide as an additive were mixed at a ratio of 10:6. This mixture was dispersed in 0.75 parts of silicone rubber and a fluorescent color cap having a thickness of 0.5 mm was molded using a mold and a heat press. When this color cap was mounted on a blue LED which emits a light defined by x = 0.1490, y = 0.1203 in the chromaticity coordinate systems, a diffused white light having a blue tint which is defined by x = 0.3090, y = 0.3679 in the chromaticity coordinate systems was observed. In this example, the measurement was carried out through the integrating sphere.

### Production Example 6

NKP-8306 (fluophor produced by Nippon Keiko Kagakusha) and gadolinium oxide as an additive were mixed at a ratio of 10:8. This mixture was dispersed in 0.75 parts of silicone rubber and a fluorescent color cap having a thickness of 0.5 mm was molded using a mold and a heat press. When this color cap was mounted on a blue LED which emits a light defined by x = 0.1490, y = 0.1203 in the chromaticity coordinate systems, a diffused white light having a blue tint which is defined by x = 0.3138, y = 0.3734 in the chromaticity coordinate systems was observed. In this example, the measurement was carried out through the integrating sphere.

### Production Example 7

NKP-8306 (fluophor produced by Nippon Keiko Kagakusha) and gadolinium oxide as an additive were mixed at a ratio of 10:10. This mixture was dispersed in 0.75 parts of silicone rubber and a fluorescent color cap having a thickness of 0.5 mm was molded using a mold and a heat press. When this color cap was mounted on a blue LED which emits a light defined by x = 0.1490, y = 0.1203 in the chromaticity coordinate systems, a diffused white light having a blue tint which is defined by x = 0.3254, y = 0.3890 in the chromaticity coordinate systems was observed. In this example, the measurement was carried out through the integrating sphere.

As is clear from the results of the luminescent colors of the examples 3 to 7 described above, it was confirmed that a wavelength of the blue LED is more effectively excited by increasing an added amount of gadolinium.

### Production Example 8

5 parts of StellarGreen E-8 (fluophor produced by Swada) were dispersed as fluorescent substance in silicone rubber, and a fluorescent color cap having a thickness of 0.5 mm was molded using a mold and a heat press. When this color cap was mounted on a blue LED which emits a light defined by x = 0.1490, y = 0.1203 in the chromaticity coordinate systems, a diffused vivid green light defined by x = 0.1935, y = 0.7179 in the chromaticity coordinate systems was observed. In this example, the measurement was carried out through the integrating sphere.

### Production Example 9

1.5 parts of StellarGreen E-8 (fluophor produced by Swada) were dispersed as fluorescent substance in silicone rubber, and a fluorescent color cap having a thickness of 0.5 mm was molded using a mold and a heat press. When this color cap was mounted on a blue LED which emits a light defined by x = 0.1490, y = 0.1203 in the chromaticity coordinate systems, a diffused blue green light defined by x = 0.1928, y = 0.5244 in the chromaticity coordinate systems was observed. In this example, the measurement was carried out through the integrating sphere.

### Production Example 10

5 parts of Blaze E-5 (fluophor produced by Swada) were dispersed as fluorescent substance in silicone rubber, and a fluorescent color cap having a thickness of 0.5 mm was molded using a mold and a heat press. When this color cap was mounted on a blue LED which emits a light defined by x = 0.1490, y = 0.1203 in the chromaticity coordinate systems, a diffused red light defined by x = 0.6505, y = 0.3414 in the chromaticity coordinate systems was observed. In this example, the measurement was carried out through the integrating sphere.

### Production Example 11

5 parts of LunaryYellow E-27 (fluophor produced by Swada) were dispersed as fluorescent substance in silicone rubber, and a fluorescent color cap having a thickness of 0.5 mm was molded using a mold and a heat press. When this color cap was mounted on a blue LED which emits a light defined by x = 0.1490, y = 0.1203 in the chromaticity coordinate systems, a diffused yellow green light defined by x = 0.3475, y = 0.6231 in the chromaticity coordinate systems was observed. In this example, the measurement was carried out through the integrating sphere.

### Production Example 12

1.5 parts of NKP-8304 (fluophor produced by Nippon Keiko Kagakusha) were dispersed as fluorescent substance in silicone rubber, and a fluorescent color cap having a thickness of 0.5 mm was molded using a mold and a heat press. When this color cap was mounted on a blue LED which emits alight defined by x = 0.1490, y = 0.1203 in the chromaticity coordinate systems, a diffused pink light defined by x = 0.5165, y = 0.3536 in the chromaticity coordinate systems was observed. In this example, the measurement was carried out through the integrating sphere.

### Production Example 13

1.5 parts of NKP-8301 (fluophor produced by Nippon Keiko Kagakusha) were dispersed as fluorescent substance in silicone rubber, and a fluorescent color cap having a thickness of 0.5 mm was molded using a mold and a heat press. When this color cap was mounted on a blue LED which emits alight defined by x = 0.1490, y = 0.1203 in the chromaticity coordinate systems, a diffused reddish violet light defined by x = 0.4730, y = 0.2890 in the chromaticity coordinate systems was observed. In this example, the measurement was carried out through the integrating sphere.

### Production Example 14

1.5 parts of NKP-8301 (fluophor produced by Nippon Keiko Kagakusha) were dispersed as fluorescent substance in silicone rubber, and a fluorescent color cap having a thickness of 0.5 mm was molded using a mold and a heat press. When this color cap was mounted on a green LED which emits a light defined by x = 0.4686, y = 0.5282 in the chromaticity coordinate systems, a diffused orange light defined by x = 0.5720, y = 0.4253 in the chromaticity coordinate systems was observed. In this example, the measurement was carried out through the integrating sphere.

### Production Example 15

1.5 parts of NKP-8304 (fluophor produced by Nippon Keiko Kagakusha) were dispersed as fluorescent substance in silicone rubber, and a fluorescent color cap having a thickness of 0.5 mm was molded using a mold and a beat press. When this color cap was mounted on a green LED which emits a light defined by x = 0.4686, y = 0.5282 in the chromaticity coordinate systems, a diffused orange light having a yellow tint which is defined by x = 0.5457, y = 0.4522 in the chromaticity coordinate systems was observed. In this example, the measurement was carried out through the integrating sphere.

### Production Example 16

NKP-8315 (fluophor produced by Nippon Keiko Kagakusha) and NKP-8304 (fluophor produced by Nippon Keiko Kagakusha) were mixed as fluorescent substance at a ratio of 10:1. 0.75 parts of this mixture were dispersed in silicone rubber, and a fluorescent color cap having a thickness of 0.5 mm was molded using a mold and a heat press. When this color cap was mounted on a blue LED which emits a light defined by x = 0.1490, y = 0.1203 in the chromaticity coordinate systems, a diffused white light having a green tint which is defined by x = 0.3486, y = 0.4595 in the chromaticity coordinate systems was observed. In this example, the measurement was carried out through the integrating sphere.

### Production Example 17

NKP-8315 (fluophor produced by Nippon Keiko Kagakusha) and NKP-8304 (fluophor produced by Nippon Keiko Kagakusha) were mixed as fluorescent substance at a ratio of 10:3. 0.75 parts of this mixture were dispersed in silicone rubber, and a fluorescent color cap having a thickness of 0.5 mm was molded using a mold and a heat press. When this color cap was mounted on a blue LED which emits a light defined by x = 0.1490, y = 0.1203 in the chromaticity coordinate systems, a diffused white light having a yellow tint which is defined by x = 0.4107, y = 0.4198 in the chromaticity coordinate systems was observed. In this example, the measurement was carried out through the integrating sphere.

### Production Example 18

NKP-8315 (fluophor produced by Nippon Keiko Kagakusha) and NKP-8304 (fluophor produced by Nippon Keiko Kagakusha) were mixed as fluorescent substance at a ratio of 10:5. 0.75 parts of this mixture were dispersed in silicone rubber, and a fluorescent color cap having a thickness of 0.5 mm was molded using a mold and a heat press. When this color cap was mounted on a blue LED which emits a light defined by x = 0.1490, y = 0.1203 in the chromaticity coordinate systems, a diffused white light having an orange tint which is defined by x = 0.4445, y = 0.4070 in the chromaticity coordinate systems was observed. In this example, the measurement was carried out through the integrating sphere.

### Production Example 19

NKP-8315 (fluophor produced by Nippon Keiko Kagakusha) and NKP-8304 (fluophor produced by Nippon Keiko Kagakusha) were mixed as fluorescent substance at a ratio of 10:10. 0.75 parts of this mixture were dispersed in silicone rubber, and a fluorescent color cap having a thickness of 0.5 mm was molded using a mold and a heat press. When this color cap was mounted on a blue LED which emits a light defined by x = 0.1490, y = 0.1203 in the chromaticity coordinate systems, a diffused white light having a red tint which is defined by x = 0.4634, y = 0.3839 in the chromaticity coordinate systems was observed. In this example, the measurement was carried out through the integrating sphere.

As is clear from the results of the diffused lights seen in the production examples 16 to 19, the color of the LED can freely be changed by arbitrarily changing a combination of a variety of fluorescent substances and a mixing ratio and a concentration thereof.

### Production Example 20

1.5 parts of NKP-8306 (fluophor produced by Nippon Keiko Kagakusha) were dispersed as fluorescent substance in Akylbet MD (Mitsubishi Rayon Co., Ltd.) which is an acrylic resin, and a fluorescent color cap having a thickness of 0.5 mm was molded using a mold and a heat press. When this color cap was mounted on a blue LED which emits a light defined by x = 0.1490, y = 0.1203 in the chromaticity coordinate systems, a result similar to that of the example 1 was obtained. In this example, the measurement was carried out through the integrating sphere.

### Production Example 21

1.5 parts of NKP-8306 (fluophor produced by Nippon Keiko Kagakusha) were dispersed as fluorescent substance in Mitsubishi Polyethy-HD HJ390 (Mitsubishi Chemical Co., Ltd.) which is a high density polystyrene, and a fluorescent color cap having a thickness of 0.5 mm was molded using a mold and a heat press. When this color cap was mounted on a blue LED which emits a light defined by x = 0.1490, y = 0.1203 in the chromaticity coordinate systems, a result similar to that of the example 1 was obtained. In this example, the measurement was carried out through the integrating sphere.

### Production Example 22

1.5 parts of NKP-8306 (fluophor produced by Nippon Keiko Kagakusha) were dispersed as fluorescent substance in Cepton 2043 (Kuraray Co., Ltd.) which is a styrene thermoplastic elastomer, and a fluorescent color cap having a thickness of 0.5 mm was molded using a mold and a heat press. When this color cap was mounted on a blue LED which emits a light defined by x = 0.1490, y = 0.1203 in the chromaticity coordinate systems, a result similar to that of the example 1 was obtained. In this example, the measurement was carried out through the integrating sphere.

### Production Example 23

40 parts of YAG fluophor (yttrium 28.0 wt%, aluminum 13.6 wt%, gadolinium 56.62 wt%, cerium 1.23 wt%), were dispersed as fluorescent substance in silicone rubber, and a fluorescent color cap having a thickness of 0.6 mm was molded using a mold and a heat press.

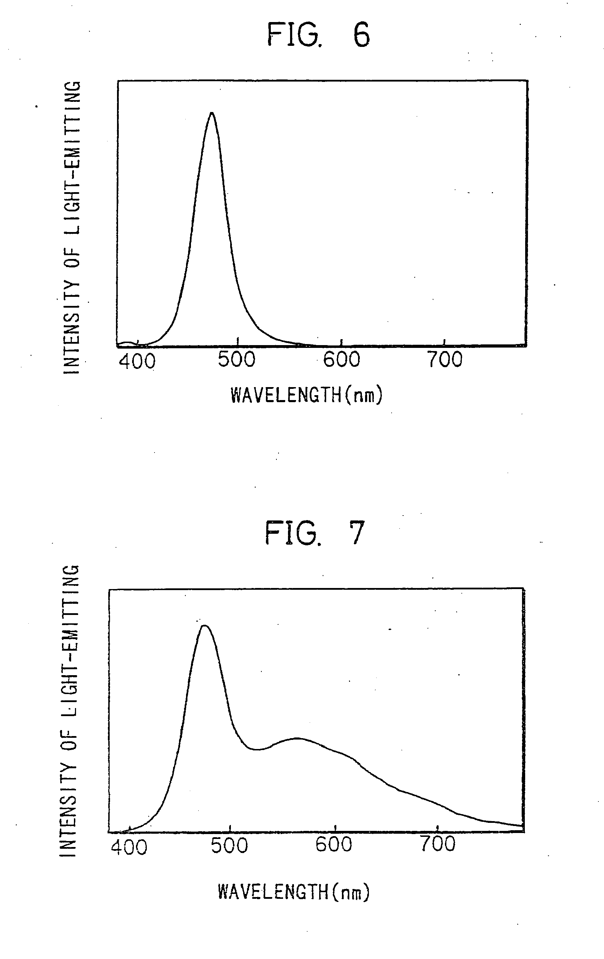

Further, a blue LED which emits a light defined by x = 0.1275, y = 0.0883 in accordance with the chromaticity coordinate systems and having a luminance of 28.95 cd/m² was used. FIG. 6 shows a spectral wavelength of this blue LED. When this blue LED was caused to emit a light with the fluorescent color cap mounted thereon, a diffused white light defined by x = 0.3192, y = 0.3375 in the chromaticity coordinate systems and having a luminance of 66.36 cd/m² was observed. The spectral wavelength at this time is shown in FIG. 7. In this example, the measurement was carried out through the integrating sphere.

### Production Example 24

12.5 parts of YAG fluophor (yttrium 28.0 wt%, aluminum 13.6 wt%, gadolinium 56.62 wt%, cerium 1.23 wt%), were dispersed as fluorescent substance in silicone rubber, and an elastic sheet having a thickness of 0.5 mm was produced.

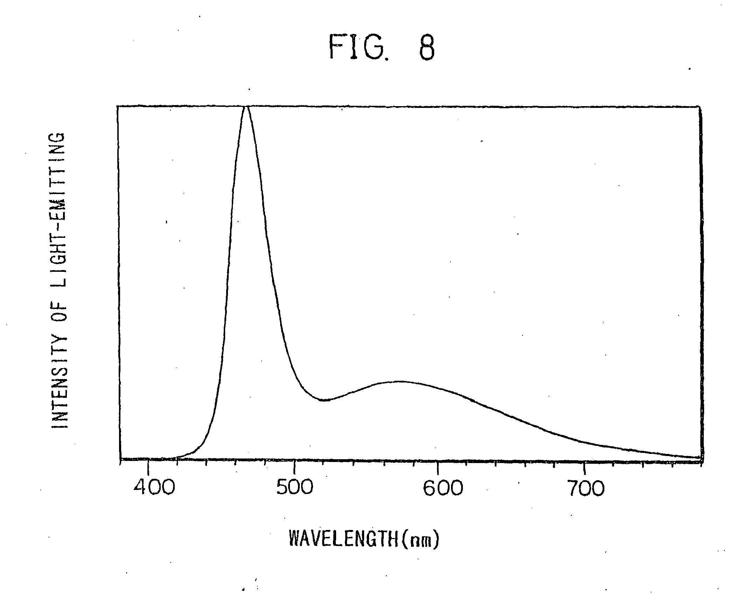

Using the blue LED used in the production example 23, the above elastic sheet was mounted in a position 5 mm away from the blue LED, which was then turned on by applying a current of 20 mA. Upon measuring a light diffused by passing through the elastic sheet, a diffused white light defined by x = 0.2667, y = 0.2725 in the chromaticity coordinate systems and having a luminance of 1629 cd/m² was observed. The spectral wavelength at this time is shown in FIG. 8. In this example, the measurement was carried out not through the integrating sphere.

### Production Example 25

0.2 parts of "Lumogen ORANGE F" (produced by BASF GmbH) which is a perylene fluorescent dye having a light gathering property were dispersed as fluorescent substance in silicone rubber, and a fluorescent color cap having a thickness of 0.5 mm was produced using a mold and a heat press.

Using the blue LED used in the production example 23, the above fluorescent color cap was mounted on the blue LED, which was then turned on by applying a current of 20 mA. As a result, a diffused white light defined by x = 0.3405, y = 0.3235 in the chromaticity coordinate systems and having a luminance of 2.124 cd/m² was observed. In this example, the measurement was carried out through the integrating sphere.

### Production Example 26

0.2 parts of "Lumogen ORANGE F" (produced by BASF GmbH) which is a perylene fluorescent dye having a light gathering property were dispersed as fluorescent substance in silicone rubber, and a fluorescent color cap having a thickness of 0.5 mm was produced using a mold and a heat press.

Using the blue LED used in the production example 23, the above fluorescent color cap was mounted on the blue LED, which was then turned on by applying a current of 20 mA. As a result, a yellow green light defined by x = 0.1859, y = 0.6108 in the chromaticity coordinate systems and having a luminance of 2.708, cd/m² was observed. In this example, the measurement was carried out through the integrating sphere.

### Production Example 27

40 parts of YAG fluophor used in the production example 23 were mixed and dispersed in silicone rubber, and a fluorescent color cap having a thickness of 0.6 mm was produced using a mold and a heat press. A lens-shaped cap made of silicone rubber having a transmittance of 80 % or greater was mounted on a leading end portion of the fluorescent color cap. This fluorescent color cap was mounted on a blue LED, which was then turned on by applying a current of 20 mA. The chromaticity coordinates and luminance were measured from the front of the leading end portion of the LED. The measurement results are shown in TABLE-2. In this example, the measurement was carried out not through the integrating sphere.

**TABLE-2**

| | X | y | Luminance (cd/m²) |
|---|---|---|---|
| Cap Mounted | 0.3446 | 0.3482 | 3667 |
| Lens-Equipped Cap | 0.3348 | 0.3359 | 6239 |
| Mounted | | | |

By providing the lens at the leading end portion of the fluorescent cap, the luminance of the light emitted from the front surface could be increased by about 70 % without changing the luminescent color.

### Production Example 28

12.5 parts of YAG fluophor (yttrium 28.0 wt%, aluminum 13.6 wt%, gadolinium 56.62 wt%, cerium 1.23 wt%) were dispersed as fluorescent substance in silicone rubber, and a fluorescent color cap having a thickness of 0.6 mm was produced using a mold and a heat press.

Using the blue LED used in the production example 23, the above fluorescent color cap was mounted on the blue LED, which was then turned on by applying a current of 20 mA. As a result, a diffused white light defined by x = 0.3192, y = 0.3375 in the chromaticity coordinate systems and having a luminance of 66.36 cd/m² was observed.

On the other hand, 0.03 parts of condensation azo dye were dispersed as a red coloring agent in silicone rubber, and a colored cap having a thickness of 0.5 mm was molded using a mold and a heat press.

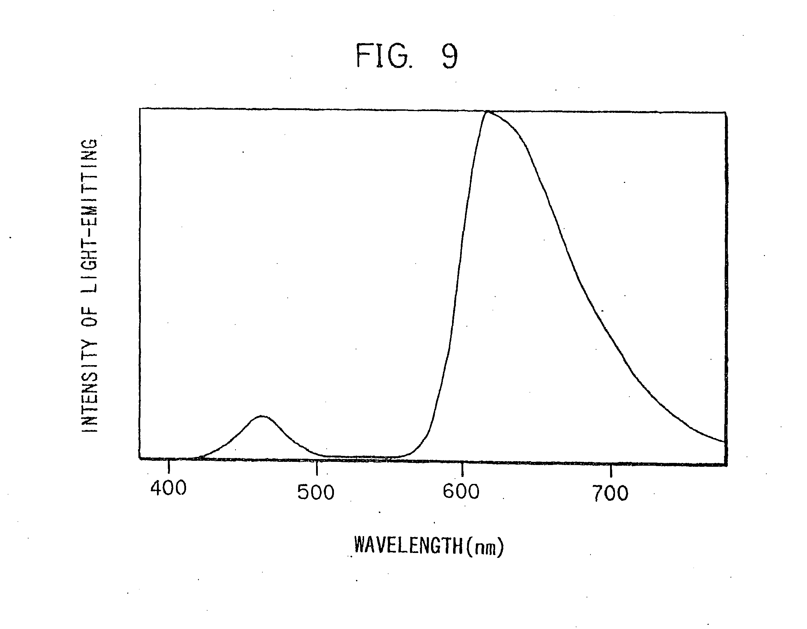

This colored cap was mounted on the LED having the fluorescent color cap mounted thereon, and the LED was caused to emit a light. As a result, a diffused red light defined by x = 0.5997, y = 0.3081 in the chromaticity coordinate systems and having a luminance of 9.813 cd/m² was observed. The spectral wavelength at this time is shown in FIG. 9. In this example, the measurement was carried out through the integrating sphere.

### Production Example 29

0.03 parts of phthalocyanine green were dispersed as a green coloring agent in silicone rubber, and a colored cap having a thickness of 0.5 mm was molded using a mold and a heat press.

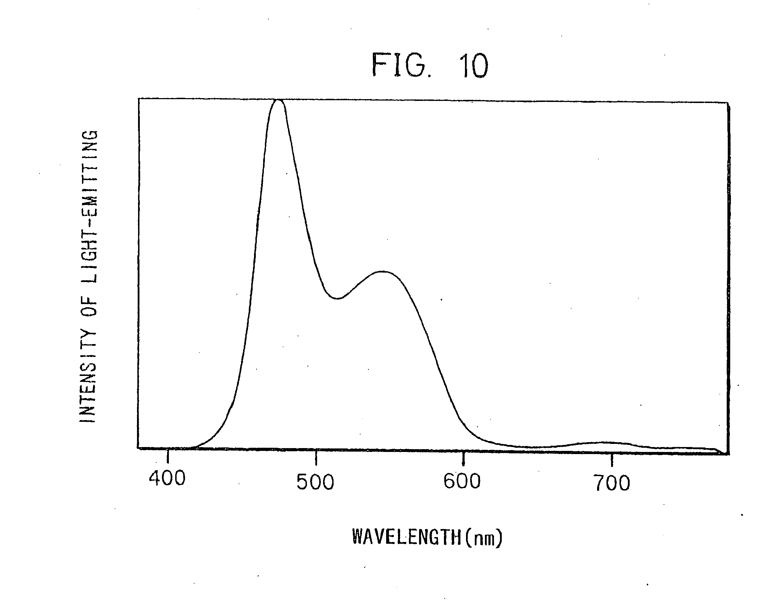

Similar to the production example 28, this colored cap was mounted on the LED having the fluorescent color cap mounted thereon, and the LED was caused to emit a light. As a result, a diffused green light defined by x = 0.2127, y = 0.3702 in the chromaticity coordinate systems and having a luminance of 32.38 cd/m² was observed. The spectral wavelength at this time is shown in FIG. 10. In this example, the measurement was carried out through the integrating sphere.

### Production Example 30

A colored cap was molded in the same way as in the production example 29 except that an amount of the green coloring agent in use was changed from 40 parts to 80 parts. This colored cap was mounted on the LED having the fluorescent color cap mounted thereon, and the LED was caused to emit a light. As a result, a diffused green light defined by x = 0.1859, y = 0.3971 in the chromaticity coordinate systems and having a luminance of 22.34 cd/m² was observed. In this example, the measurement was carried out through the integrating sphere.

### Production Example 31

0.03 parts of phthalocyanine blue were dispersed as a blue coloring agent in silicone rubber, and a colored cap having a thickness of 0.5 mm was molded using a mold and a heat press.

Similar to the production example 28, this colored cap was mounted on the LED having the fluorescent color cap mounted thereon, and the LED was caused to emit a light. As a result, a diffused blue light defined by x = 0.1236, y = 0.1585 in the chromaticity coordinate systems and having a luminance of 10.19 cd/m² was observed. In this example, the measurement was carried out through the integrating sphere.

As is clear from the results of the Production examples 28 to 31, a desired luminescent color can be obtained if a colored cap containing a coloring agent of a desired color is further mounted on the LED which is enabled to have a white luminescent color by mounting the fluorescent color cap.

### Production Example 32

40 parts of YAG fluophor (yttrium 28.0 wt%, aluminum 13.6 wt%, gadolinium 56.62 wt%, cerium 1.23 wt%) as fluorescent substance and 0.03 parts of condensation azo dye as a red coloring agent were dispersed in silicone rubber, and a fluorescent color cap having a thickness of 0.5 mm was produced using a mold and a heat press.

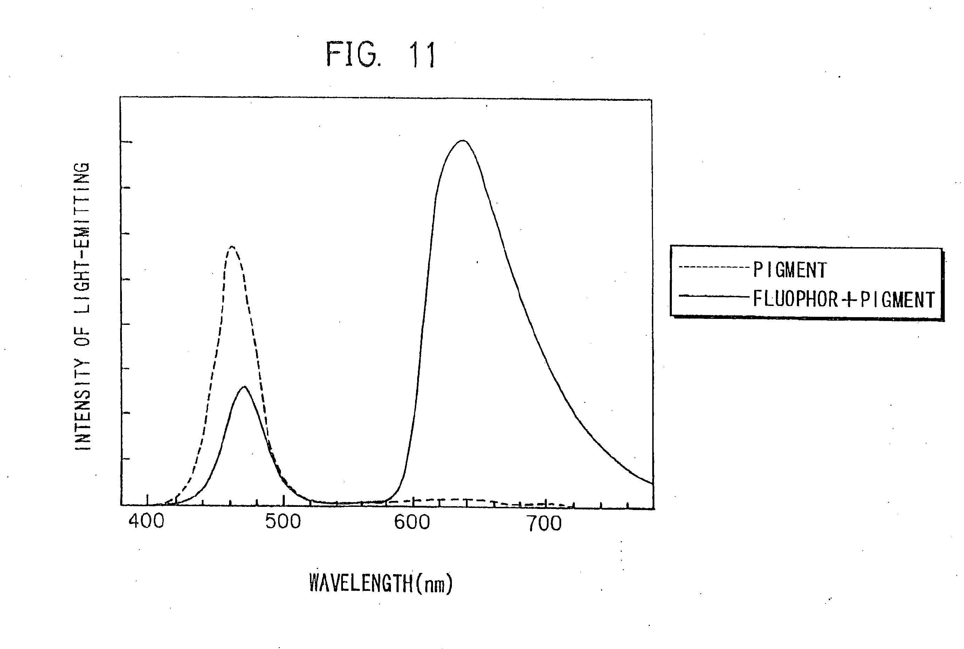

This fluorescent color cap was mounted on a blue LED, which was then caused to emit a light. Then, a blue light defined by x = 0.1275, y = 0.0883 in the chromaticity coordinate systems and having a luminance of 2.895 cd/m² became a diffused red light having a color defined by x = 0.5289, y = 0.2542 and a luminance of 0.9259 cd/m² after the mounting of the cap. A luminous intensity in relation to wavelength at this time is shown in FIG. 11. In this example, the measurement was carried out through the integrating sphere.

As is clear from the production example 32, a desired luminescent color can also be obtained by containing a coloring agent of a desired color in the fluorescent color cap.

### Production Example 33

23 parts of YAG fluophor (yttrium 28.0 wt%, aluminum 13.6wt%, gadolinium 56.62 wt%, cerium 1.23 wt%) were dispersed as fluorescent substance in silicone rubber, and a fluorescent color cap having a thickness of 0.35 mm was produced.

Using the blue LED used in the production example 23, the above cap was mounted on this blue LED, which was then turned on by applying a current of 20 mA. Lights emitted from the leading end portion and the side surface portion of the cap were measured by the spectrophotometer. The results are shown in TABLE-3. In this example, the measurement was carried out not through the integrating sphere.

**TABLE-3**

| Place of Measurement | X | y | Luminance (cd/m²) |
|---|---|---|---|
| Leading End | 0.2346 | 0.2365 | 2954 |
| Side Surface | 0.3495 | 0.3389 | 2053 |

Next, 12 parts of YAG fluophor (yttrium 28.0 wt%, aluminum 13.6wt%, gadolinium 56.62 wt%, cerium 1.23 wt%) were dispersed as fluorescent substance in silicone rubber, and a sheet piece having a thickness of 0.35 mm was produced. After mounting this sheet piece on the leading end of the cap, the chromaticity was measured again by the spectrophotometer. The result is shown in TABLE-4.

**TABLE-4**

| Place of Measurement | X | y | Luminance (cd/m²) |
|---|---|---|---|
| Leading End | 0.306 | 0.3355 | 2985 |

From these results, it can be seen that the chromaticity of the light diffused while passing through the coating member can be adjusted by changing the concentration of the fluorescent substance in the coating member.

### Production Example 34

Using a blue LED having a diameter of 3 mm, the color of the light emitted from this LED was changed by changing a value of a current flowing into the LED. A fluorescent color cap (thickness: 0.6 mm) containing a specific amount of YAG fluophor was mounted, and the luminescent color and the luminance after the mounting of the cap were measured by the spectrophotometer. The measurement results are shown in TABLE-5. In this example, the measurement was carried out through the integrating sphere.

**TABLE-5**

| Current mA | x | Y | Luminance | YAG Amount | x | y | Luminance |
|---|---|---|---|---|---|---|---|
| 5 | 0.1213 | 0.1063 | 9.71 | 5.0 | 0.2189 | 0.2320 | 14.11 |
| | | | | 10.0 | 0.2886 | 0.3165 | 20.51 |
| | | | | 15.0 | 0.3397 | 0.3767 | 23.85 |
| 10 | 0.1243 | 0.0972 | 16.48 | 5.0 | 0.2210 | 0.2216 | 29.85 |
| | | | | 10.0 | 0.2894 | 0.3076 | 40.66 |
| | | | | 10.5 | 0.2925 | 0.3105 | 43.39 |
| | | | | 15.0 | 0.3393 | 0.3694 | 43.67 |
| 20 | 0.1275 | 0.0883 | 28.95 | 5.0 | 0.2214 | 0.2132 | 53.23 |
| | | | | 10.0 | 0.2888 | 0.2991 | 70.99 |
| | | | | 11.0 | 0.2989 | 0.3102 | 78.56 |
| | | | | 15.0 | 0.3380 | 0.3612 | 81.28 |
| 30 | 0.1288 | 0.0848 | 38.51 | 5.0 | 0.2214 | 0.2094 | 71.30 |
| | | | | 10.0 | 0.2878 | 0.2957 | 96.22 |
| | | | | 11.5 | 0.3046 | 0.3124 | 111.00 |
| | | | | 15.0 | 0.3377 | 0.3577 | 109.99 |

From TABLE-5, it can be seen that, even if there is a variation in the luminescent color of the LED, the luminescent color can be adjusted within a specified range by mounting the fluorescent color cap containing the specific amount of fluorescent substance.

As described above, according to the inventive coating member containing the fluorescent substance, the luminescent color of the LED can be changed to a desired color including white by mounting this coating member on the LED.

Further, since the luminescent color is changed by exciting the wavelength of the light emitted from the LED by the fluorescent substance, a stable color balance can be obtained by a single LED. Further, since the cap-shaped coating member is molded, it is precise in dimension and easy to maintain. Furthermore, since this cap is directly mounted on the LED, no special space is necessary and can be mounted regardless of the shape of the LED.

Although the present invention has been fully described by way of example with reference to the accompanying drawings, it is to be understood that various changes and modifications will be apparent to those skilled in the art. Therefore, unless otherwise such changes and modifications depart from the scope of the present invention, they should be construed as being included therein.

## Claims

1. A method of producing a fluorescent color light source, comprising:
a step of dispersing a fluorescent substance in a resin to obtain a fluorescent-substance-containing resin;
a step of molding the fluorescent-substance-containing resin to obtain a transparent coating member; and
a step of mounting the transparent coating member on a light emitting diode.

2. The method according to claim 1, wherein the resin is a silicone elastomer.

3. The method according to claim 1 or 2, wherein in the mounting step, the transparent coating member is adhered to the light emitting diode by an adhesive.

4. The method according to claim 1 or 2, wherein in the mounting step, the transparent coating member is mounted in a position away from the light emitting diode.

5. The method according to any one of claims 1 through 4, wherein the fluorescent substance is an inorganic fluorescent substance, and
the inorganic fluorescent substance is in a range of 0.5 to 70 weight parts per 100 weight parts of the resin.

6. The method according to any one of claims 1 through 5, wherein the fluorescent substance is an inorganic fluorescent substance, and
an additive to be added to the inorganic fluorescent substance is in a range of 0.1 to 10 mol% to the inorganic fluorescent substance.

7. The method according to any one of claims 1 through 6, wherein light emitted from the fluorescent color light source has a luminescent color within a range defined by (x,y)=(0.148, 0.123), (0.199, 0.718), (0.651, 0.341), and (0.348, 0.623) in chromaticity coordinate systems.

8. The method according to any one of claims 1 through 6, wherein light emitted from the fluorescent color light source has a luminescent color within a range defined by (x,y)=(0.27, 0.19), (0.19, 0.24), (0.35, 0.48), and (0.48, 0.37) in chromaticity coordinate systems.

9. The method according to any one of claims 1 through 8, wherein the transparent coating member is in a form of a cap or a form of a sheet.

10. A transparent coating member mountable on a light-emitting diode, comprising a fluorescent substance.

11. A transparent coating member according to claim 10, wherein the fluorescent substance is an yttrium aluminate fluophor or a perylene fluophor.

12. A transparent coating member according to claim 10, wherein the coating member is in the form of a cap.

13. A transparent coating member according to claim 12, wherein the coating member includes a light gathering mechanism in a leading end portion thereof.

14. A transparent coating member according to claim 10, wherein the coating member is in the form of a sheet.

15. A fluorescent color light source comprising:
a light-emitting diode; and
a transparent coating portion provided on a surface of the light-emitting diode, the coating portion including a fluorescent substance, whereby the wavelength of an emitted light peculiar to the light-emitting diode is changed by the fluorescent substance contained in the coating portion to change the luminescent color.

16. A fluorescent color light source according to claim 15, wherein the light diffusely emitted through the coating portion has a luminescent color within a range defined by (x, y) = (0.148, 0.123), (0.199, 0.718), (0.651, 0.341) and (0.348, 0.623) in chromaticity coordinate systems.

17. A fluorescent color light source according to claim 15, wherein the light diffusely emitted through the coating portion has a luminescent color within a range defined by (x, y) = (0.27, 0.19), (0.19, 0.24), (0.35, 0.48) and (0.48, 0.37) in chromaticity coordinate systems.

18. A fluorescent color light source according to claim 15, further comprising a secondary coating portion on the transparent coating portion, the secondary coating portion containing a coloring agent.

19. A fluorescent color light source according to claim 15, wherein the coating portion includes a transparent coating layer formed on a surface of the light-emitting diode, the transparent coating layer including a fluorescent substance.

20. A fluorescent color light source according to claim 15, wherein the coating portion includes a transparent coating member separable from the light-emitting diode, the transparent coating member including a fluorescent substance.

21. A fluorescent color light source according to claim 20, further comprising a holder which detachably holds the transparent coating member on the light-emitting diode.

22. A fluorescent color light source according to claim 20, wherein the coating member is in the form of a cap.

23. A fluorescent color light source according to claim 22, wherein the coating member includes a light gathering mechanism in a leading end portion thereof.

24. A fluorescent color light source according to claim 20, wherein the coating member is in the form of a sheet.

25. A fluorescent color light source according to claim 15, wherein the light-emitting diode is a light-emitting diode which emits blue light at a high energy.

26. A fluorescent color light source according to claim 15, wherein the light-emitting diode is a light-emitting diode which emits green light at a high energy.

27. A fluorescent color light source according to claim 15, wherein the fluorescent substance is an yttrium aluminate fluophor or a perylene fluophor.
